Europäisches Patentamt

(19) European Patent Office

Office européen des brevets

(11) Veröffentlichungsnummer : **0 280 103 B1**

# (12) EUROPÄISCHE PATENTSCHRIFT

(45) Veröffentlichungstag der Patentschrift :
10.04.91 Patentblatt 91/15

(21) Anmeldenummer : 88101761.0

(22) Anmeldetag : 06.02.88

(51) Int. Cl.⁵ : **G03F 7/18**

---

(54) Verfahren zum Beschichten von Formzylindern oder Formzylinder-Hülsen mit einer durchgehenden, nahtlosen lichtempfindlichen Schicht sowie Verwendung der so beschichteten Formzylinder bzw. Formzylinder-Hülsen zur Herstellung von Druckformen für den Rotationsdruck.

---

(30) Priorität : 14.02.87 DE 3704695

(43) Veröffentlichungstag der Anmeldung :
31.08.88 Patentblatt 88/35

(45) Bekanntmachung des Hinweises auf die
Patenterteilung :
10.04.91 Patentblatt 91/15

(84) Benannte Vertragsstaaten :
BE DE FR GB IT NL

(56) Entgegenhaltungen :
FR-A- 2 391 072
NL-A- 8 501 052
US-A- 4 266 007
US-A- 4 349 620

(56) Entgegenhaltungen :
CHEMICAL ABSTRACTS, Band 95, Nr. 4, August 1981, Seite 624, Zusammenfassung Nr. 71071w, Columbus, Ohio, US; & SU-A-826 263 (UKRAINIAN PRINTING INSTITUTE; SCIENTIFIC-RESEARCH INSTITUTE OF RUBBER AND LATEX ARTICLES) 30-04-1981
CHEMICAL ABSTRACTS, Band 86, Nr. 18, 2. Mai 1977, Seite 665, Zusammenfassung Nr. 131165f, Columbus, Ohio, US; & SU-A-542 661 (UKRAINIAN SCIENTIFIC-RESEARCH INSTITUTE OF THE PRINTING INDUSTRY) 15-01-1977

(73) Patentinhaber : BASF Aktiengesellschaft
Carl-Bosch-Strasse 38
W-6700 Ludwigshafen (DE)

(72) Erfinder : Wallbillich, Guenter, Dr.
Erschigweg 19
W-6730 Neustadt (DE)
Erfinder : Van Heuvelen, Jan Hendrik
Hogeweg 123
NL-7502 CC Losser (NL)

## Beschreibung

Die Erfindung betrifft ein Verfahren zum Beschichten von Formzylindern oder Formzylinder-Hülsen durch haftfestes Aufbringen einer vorgefertigten, festen, thermoplastisch verarbeitbaren lichtempfindlichen Schicht auf den Formzylinder bzw. die Formzylinder-Hülse unter Ausbildung einer durchgehenden, nahtlosen lichtempfindlichen Schicht unter dem Einfluß von Wärme und Druck. Die Erfindung betrifft ferner die Verwendung der so mit einer nahtlosen lichtempfindlichen Schicht beschichteten Formzylinder bzw. Formzylinder-Hülsen zur Herstellung von Druckformen für den Rotationsdruck, insbesondere Rollenrotationstiefdruck- oder -flexodruckformen für den Endlosdruck.

Die Herstellung von Druckformen mittels lichtempfindlicher Schichten ist an sich bekannt. Die hierfür üblicherweise eingesetzten lichtempfindlichen Aufzeichnungsschichten sind im allgemeinen photopolymerisierbar und/oder photovernetzbar und enthalten in der Regel neben einem polymeren Bindemittel mindestens eine photopolymerisierbare und/oder photovernetzbare Verbindung, einen Photoinitiator sowie weitere Zusatz-und/oder Hilfsstoffe. Wegen der leichten und einfachen Verarbeitbarkeit werden hierbei vielfach thermoplastisch verarbeitbare lichtempfindliche Schichten verwendet. Zur Herstellung der Druckformen werden die auf einem dimensionsstabilen Träger haftfest aufgebrachten lichtempfindlichen Aufzeichnungsschichten bildmäßig mit aktinischem Licht belichtet und anschließend in geeigneter Weise, beispielsweise durch Auswaschen mit einem Entwicklerlösungsmittel, entwickelt. Je nachdem, ob die lichtempfindliche Schicht negativ oder positiv arbeitend ist, werden bei der Entwicklung der Druckformen die unbelichteten oder belichteten Bereiche der Schicht entfernt.

Für den Rotationsdruck werden Druckzylinder oder Druckzylinder-Hülsen ("sleeves") eingesetzt, wobei es für die Herstellung von Endlosdrucken erforderlich ist, daß die Druckschicht ein fortlaufendes Druckmuster ohne Unterbrechungen aufweist. Will man solche Druckzylinder oder Druckzylinder-Hülsen mittels der heute für die Herstellung von Druckformen üblichen und gebräuchlichen lichtempfindlichen Aufzeichnungsmaterialien herstellen, so ist es erforderlich, einen Formzylinder oder eine Formzylinder-Hülse, die später zum Drucken auf einen entsprechenden Formzylinder aufgeschoben wird, mit einer durchgehenden, nahtlosen lichtempfindlichen Schicht zu beschichten. Die hierfür bereits vorgeschlagene Lösungsbeschichtung ist umständlich, sehr zeitaufwendig und schwierig durchzuführen, insbesondere, wenn man gleichmäßige dicke lichtempfindliche Schichten auf den Formzylinder bzw. die Formzylinder-Hülse aufbringen muß.

Es ist auch schon vorgeschlagen worden, einen Formzylinder oder eine Formzylinder-Hülse mit einer Lage einer vorgefertigten, festen, thermoplastisch verarbeitbaren lichtempfindlichen Schicht zu umwickeln, wobei nach der Umwicklung die Kanten der Endabschnitte der lichtempfindlichen Schicht aneinander stoßen und eine Nahstelle bilden. So beschichtete Formzylinder oder Formzylinder-Hülsen lassen sich nicht ohne weiteres für die Herstellung von Druckformen für den Rollenrotationsdruck einsetzen, sondern erfordern ein entsprechendes Verbinden der Stoßkanten der lichtempfindlichen Schicht an der oder den Nahtstellen zur Erzeugung einer durchgehenden, nahtlosen, lichtempfindlichen Schicht auf dem Formzylinder bzw. der Formzylinder-Hülse. Es ist bekannt, ein solches nahtloses Verbinden der aneinander stoßenden Kanten von um Formzylinder oder Formzylinder-Hülsen gewickelten thermoplastisch verarbeitbaren lichtempfindlichen Schichten durch Verschweißen der Stoßkanten unter dem Einfluß von Wärme und Druck vorzunehmen. Zum Stand der Technik sei hierzu beispielsweise auf die DE-A-27 22 896, DE-A-28 44 426, DE-A-28 42 440, DE-A-29 11 908, EP-B-40 893, EP-A-43 623 und EP-A-111 371 verwiesen.

Neben dem Erfordernis des genauen Zuschnitts der lichtempfindlichen Schichten auf den Umfang der zu beschichtenden Formzylinder bzw. Formzylinder-Hülsen bringt die letztgenannte Verfahrensweise den weiteren Nachteil mit sich, daß die ausgebildete Schweißnaht häufig nur relativ schwach und mechanisch wenig beanspruchbar ist. Eine formgebende, mechanische Nachbehandlung der nach den bekannten Verfahren verschweißten lichtempfindlichen Schichten, beispielsweise durch Abdrehen, Abspänen oder dgl., wie sie in aller Regel zur Ausbildung einer exakt-zylindrischen Oberfläche, insbesondere bei Einsatz von konisch zulaufenden Formzylinder-Hülsen, notwendig und erforderlich ist, ist daher nur schlecht oder gar nicht möglich. Weiterhin können nach diesen bekannten Verfahren nur dicke vorgefertigte lichtempfindliche Schichten verarbeitet werden, die in ihrer Dicke zudem auf die letztlich gewünschte Schichtstärke für die Beschichtung abgestimmt sein müssen. Für eine Anpassung der Dicke der druckenden Schicht der so hergestellten Rotationsdruckzylinder an wechselnde Druckanforderungen ist es daher notwendig, stets verschiedene vorgefertigte lichtempfindliche Schichten entsprechender unterschiedlicher Stärke vorrätig zu haben. Die bekannten Verfahren zum Beschichten eines Formzylinders oder einer Formzylinder-Hülse mit einer durchgehenden, nahtlosen gleichmäßigen lichtempfindlichen Schicht sind daher aufwendig und wenig flexibel.

Es ist ebenfalls bereits bekannt, lichtempfindliche Schichten für die Herstellung von photopolymeren Druckplatten aus 2 oder mehr Lagen aufzubauen (vergl. z.B. Chemical Abstracts, Band 95, Nr. 4, August 1981, Seite 624, Nr. 71071w sowie Chemical Abstracts, Band 86, Nr. 18, Mai 1977, Seite 665, Nr. 131165f). Einen Hinweis auf die mehrfache Umwicklung von Formzylindern oder Formzylinder-Hülsen mit einer vorgefertigten bahnförmigen lichtempfindlichen Schicht läßt sich in diesem Stand der Technik jedoch nicht finden.

Aufgabe der vorliegenden Erfindung war es, ein Verfahren zum Beschichten eines Formzylinders oder einer Formzylinder-Hülse mit einer durchgehenden nahtlosen gleichmäßigen lichtempfindlichen Schicht durch Aufbringen einer vorgefertigten, festen lichtempfindlichen Schicht aufzuzeigen, welches einfach durchführbar, variabel und breit anwendbar ist, die Variation der Dicke der aufgebrachten Schicht in einfacher Weise erlaubt und weitgehend Freiheit bezüglich Art und Form der einzusetzenden vorgefertigten lichtempfindlichen Schichten gewährt. Die nach diesem Verfahren mit der durchgehenden, nahtlosen lichtempfindlichen Schicht beschichteten Formzylinder oder Formzylinder-Hülsen sollen sich auf übliche Art und Weise durch bildmäßiges Belichten mit aktinischem Licht und Entwickeln in Druckformen überführen lassen, die für den Rotationsdruck, insbesondere für den Endlosdruck, verwendbar sind und gute Druckergebnisse liefern. Das Verfahren soll insbesondere auch den Einsatz von konisch zulaufenden Formzylinder-Hülsen ohne Einschränkung erlauben.

Es wurde nun überraschend gefunden, daß diese Aufgabe gelöst wird durch ein Verfahren der in Rede stehenden Art, bei dem eine dünne, im wesentlichen lösungsmittelfreie, trägerfreie, vorgefertigte, feste, bahn- oder bandförmige thermoplastisch verarbeitbare lichtempfindliche Schicht mehrfach in mindestens zwei Lagen blasenfrei unter Verdrängung der Luft zwischen den einzelnen Lagen um den Formzylinder bzw. die Formzylinder-Hülse gewickelt wird, worauf die gesamte aufgebrachte lichtempfindliche Schichtmasse unter Druck und Verbinden bzw. Verschmelzen der einzelnen Lagen erwärmt und anschließend die so auf dem Formzylinder bzw. der Formzylinder-Hülse erzeugte durchgehend verbundene lichtempfindliche Schicht unter Ausbildung einer exakt zylindrischen Oberfläche maßgenau formgebend nachbehandelt und geglättet wird.

Gegenstand der Erfindung ist dementsprechend ein Verfahren zum Beschichten eines Formzylinders oder einer Formzylinder-Hülse mit einer durchgehenden nahtlosen lichtempfindlichen Schicht durch haftfestes Aufbringen einer vorgefertigten, festen, thermoplastisch verarbeitbaren lichtempfindlichen Schicht auf den Formzylinder bzw. die Formzylinder-Hülse unter dem Einfluß von Wärme und Druck, welches dadurch gekennzeichnet ist, daß es sich bei der vorgefertigten, festen, thermoplastisch verarbeitbaren lichtempfindlichen Schicht um eine dünne, im wesentlichen lösungsmittelfreie, trägerfreie bahnoder bandförmige lichtempfindliche Schicht handelt, die mehrfach in mindestens zwei übereinanderliegenden Lagen blasenfrei unter Verdrängung der Luft zwischen den einzelnen Lagen um den Formzylinder bzw. die Formzylinder-Hülse gewickelt wird, worauf die gesamte aufgebrachte lichtempfindliche Schichtmasse unter Druck und Verbinden bzw. Verschmelzen der einzelnen Lagen erwärmt und anschließend die so auf dem Formzylinder bzw. der Formzylinder-Hülse erzeugte durchgehend verbundene lichtempfindliche Schicht unter Ausbildung einer exakt zylindrischen Oberfläche maßgenau formgebend nachbehandelt und geglättet wird.

Mit dem erfindungsgemäßen Verfahren lassen sich Formzylinder oder Formzylinder-Hülsen einfach und leicht mit einer durchgehenden, nahtlosen, glatten lichtempfindlichen Schicht beschichten, deren Dicke variierbar und damit an die veränderlichen, druckseitig geforderten Voraussetzungen problemlos anpaßbar ist. Das erfindungsgemäße Verfahren erlaubt aufgrund der vielfach möglichen Ausführungs- und Ausgestaltungsformen eine breite und allgemeine Anwendung. Die erfindungsgemäß auf den Formzylinder bzw. die Formzylinder-Hülse aufgebrachte durchgehend verbundene lichtempfindliche Schicht ist mechanisch beständig und beanspruchbar und läßt sich in an sich bekannter Weise zu Druckformen verarbeiten. Ein weiterer Vorteil des erfindungsgemäßen Verfahrens ist es, daß der exakte Zuschnitt für die vorgefertigten, thermoplastisch verarbeitbaren lichtempfindlichen Schichten, mit denen die Formzylinder bzw. Formzylinder-Hülsen beschichtet werden sollen, entfällt und das erfindungsgemäße Verfahren damit eine weitgehende Freiheit bezüglich der einzusetzenden vorgefertigten lichtempfindlichen Schichten ermöglicht.

Im Rahmen dieser Erfindung werden unter lichtempfindlichen Schichten insbesondere lichtempfindliche Aufzeichnungsschichten verstanden.

Für den Einsatz in dem erfindungsgemäßen Verfahren kommen beliebige, thermoplastisch verarbeitbare, feste lichtempfindliche Schichten in Betracht, die unter dem Einfluß von Wärme und Druck miteinander verbunden oder verschmolzen werden können, ohne daß hierdurch ihre lichtempfindlichen Eigenschaften beeinträchtigt werden. Hierzu gehören insbesondere die festen, polymeren lichtempfindlichen Schichten, die bei Erwärmung erweichen und unter Druck verfließen bzw. verkleben, wie sie für die Herstellung von Druckformen an sich bekannt sind. Neben photoabbaubaren System sind hier vor allem die positiv oder negativ arbeitenden, lichtempfindlichen, photopolymerisierbaren Schichten zu nennen. Geeignete photopolymerisierbare Schichten enthalten im allgemeinen mindestens ein thermoplastisch verarbeitbares polymeres Bindemittel, wie z.B. lösliche Polyamide, teilverseifte Polyvinylacetate, weichgemachte Polyvinylalkohole oder Polyvinylalkohol-Derivate, Polyurethane, Dienpolymerisate, wie z.B. Blockcopolymerisate aus Styrol, Butadien und/oder Isopren oder Butadien/Acrylnitril-Copolymerisate, mindestens eine niedermolekulare, ethylenisch ungesättigte, photopolymerisierbare Verbindung, wie z.B. die bekannten, (Meth)acrylat- oder (Meth)acrylamido-Gruppen enthaltenden Monomeren, mindestens einen Photopolymerisationsinitiator, wie z.B. Benzoinether, Benzilmonoketale oder Acylphosphinoxide, sowie übliche Zusatz- und/oder Hilfsstoffe, wie z.B. thermische Polymerisationsinhibitoren, Farbstoffe, Pigmente, Füllstoffe, Weichmacher, Verlaufshilfsmittel, sensitometrische Regler, etc.. Insbesondere kommen für das erfindungsgemäße Verfahen die lichtempfindlichen, photopolymerisierbaren Schichten in Betracht, wie sie für die Herstellung von Hochdruckformen, einschließlich Flexodruckformen, oder Tiefdruckformen bekannt und beschrieben sind (vgl. z.B. DE-A-22 15 090, DE-A-29 02 412, EP-B-27 612, DE-A-20 61 287, EP-A-70 510, EP-A-70 511).

Die Dicke der erfindungsgemäß einzusetzenden vorgefertigten, thermoplastisch verarbeitbaren lichtempfindlichen Schichten ist im Vergleich zu der gesamten Dicke der lichtempfindlichen Schicht, die der Formzylinder bzw. die Formzylinder-Hülse nach der Beschichtung aufweisen soll, dünn. Die Dicke der eingesetzten, vorgefertigten lichtempfindlichen Schichten richtet sich neben der gewünschten Gesamtdicke nach der Beschichtung auch nach der Anzahl der Lagen, in der diese vorgefertigten, dünnen lichtempfindlichen Schichten auf den Formzylinder bzw. die Formzylinder-Hülse aufgebracht werden sollen. Üblicherweise liegt die Dicke der erfindungsgemäß einzusetzenden, vorgefertigten, dünnen lichtempfindlichen Schichten im Bereich von etwa 20 μm bis etwa 2 mm, vorzugsweise im Bereich von etwa 30 μm bis 1000 μm. Die dünneren Schichten erlauben dabei eine größere Variabilität des erfindungsgemäßen Verfahrens.

Die in dem erfindungsgemäßen Verfahren einzusetzenden, vorgefertigten, thermoplastisch verarbeitbaren lichtempfindlichen Schichten sollen lösungsmittelfrei und trägerfrei sein. Lösungsmittelfrei bedeutet dabei im Rahmen dieser Erfindung, daß die einzusetzenden, vorgefertigten lichtempfindlichen Schichten keine wesentliche Menge eines Lösungsmittels, beispielsweise von ihrer Herstellung her, enthalten sollen. Gleichwohl können sie eine geringe Restmenge an Lösungsmittel, beispielsweise unter 5 Gew.%, insbesondere unter 2 Gew.%, bezogen auf die vorgefertigte lichtempfindliche Schicht, aufweisen. Wesentlich ist, daß der Lösungsmittelgehalt der erfindungsgemäß einzusetzenden, vorgefertigten lichtempfindlichen Schichten so gering ist, daß diese unter den Verarbeitungsbedingungen in dem erfindungsgemäßen Verfahren nicht gasen. Vorteilhafterweise geht man daher für das erfindungsgemäße Verfahren von solchen vorgefertigten lichtempfindlichen Schichten aus, die lösungsmittelfrei durch Kneten, Extrudieren, Kalandrieren, Pressen etc. hergestellt worden sind.

Um ein haftfestes Verschmelzen bzw. Verkleben der einzelnen übereinanderliegenden Lagen der vorgefertigten lichtempfindlichen Schicht in dem erfindungsgemäßen Verfahren unter Ausbildung einer einzigen dicken durchgehenden lichtempfindlichen Schicht zu ermöglichen, versteht es sich von selbst, daß die erfindungsgemäß einzusetzenden vorgefertigten lichtempfindlichen Schichten trägerfrei sind. Vorzugsweise, aber nicht zwingender Maßen, kommen daher in dem erfindungsgemäßen Verfahren selbsttragende vorgefertigte lichtempfindliche Schichten zum Einsatz. Es ist auch möglich, daß die einzusetzenden lichtempfindlichen Schichten zunächst auf einem temporären Träger, beispielsweise einer Kunststoff-Folie, aufgebracht sind, der dann unmittelbar vor dem Einsatz der vorgefertigten lichtempfindlichen Schichten in dem erfindungsgemäßen Verfahren, z.B. durch Abziehen, entfernt wird.

Für die Formzylinder bzw. Formzylinder-Hülsen, die erfindungsgemäß mit den lichtempfindlichen Schichten beschichtet werden sollen, kommen die für die Herstellung von Rotationsdruckformen üblichen und gebräuchlichen Zylinder oder zylindrischen Hülsen, insbesondere auch die konisch zulaufenden Formzylinder-Hülsen, in Betracht. Während die Formzylinder üblicherweise aus Metall bestehen, können die Formzylinder-Hülsen aus Metall, Kunststoffen, glasfaserverstärkten Kunststoffen oder dgl. gebildet sein. Die Oberfläche der Formzylinder bzw. Formzylinder-Hülsen kann glatt oder rauh bzw. strukturiert sein, um beispielsweise eine bessere Haftung zu der lichtempfindlichen Schicht zu erzielen. Die Oberfläche der Formzylinder bzw. der Formzylinder-Hülsen kann auch zur Erzielung einer guten Haftung zu der lichtempfindlichen Schicht mit einem Haftlack, einer Haftschicht, einem Schmelzkleber oder dgl. versehen sein. Das Fixieren der unteren Lage der vorgefertigten lichtempfindlichen Schicht auf dem Formzylinder bzw. der Formzylinder-Hülse kann auch beispielsweise mittels eines doppelseitigen Klebebandes erfolgen. Die Formzylinder bzw. Formzylinder-Hülsen können auch beispielsweise mit einer Kunststoff- oder Kautschukschicht beschichtet sein. Formzylinder-Hülsen sind in einer bevorzugten Ausführungsform des erfindungsgemäßen Verfahrens vor dem Beschichten mit der lichtempfindlichen Schicht mit einem textilen Gewirke umhüllt.

Die in dem erfindungsgemäßen Verfahren einzusetzenden, vorgefertigten, thermoplastisch verarbeitbaren, festen, dünnen lichtempfindlichen Schichten sind bahn- oder bandförmig. Gemäß einer besonderen Ausführungsform des erfindungsgemäßen Verfahrens werden solche vorgefertigten lichtempfindlichen Schichten eingesetzt, deren Endbereiche, die beim Auflegen der lichtempfindlichen Schichten auf den Formzylinder bzw. die Formzylinder-Hülse im allgemeinen achsparallel verlaufen, abgeflacht, insbesondere keilförmig abgeschrägt, sind. Als besonders günstig hat es sich dabei erwiesen, wenn die Endkanten der unteren Lage bzw. Lagen der übereinander gelegten vorgefertigten, lichtempfindlichen Schichten keilförmig abgeschrägt sind, und zwar insbesondere derart, daß hierbei die keilförmige Abschrägung von der jeweils darüber liegenden Lage weg nach unten hin gerichtet ist.

Das Belegen der Formzylinder bzw. Formzylinder-Hülsen mit mehreren Lagen der vorgefertigten, dünnen lichtempfindlichen Schichten kann nach mehreren Methoden erfolgen. In einer Ausführungsform des erfindungsgemäßen Verfahrens wird hierzu eine vorgefertigte, bahnförmige, dünne lichtempfindliche Schicht mehrfach, mindestens zweimal, um den Formzylinder bzw. die Formzylinder-Hülse gewickelt. Die Anzahl der Umwicklungen entspricht dabei der Anzahl der Lagen. Natürlich ist es auch möglich, für diese Umwicklung des Formzylinders bzw. der Formzylinder-Hülse nicht nur eine vorgefertigte, bahnförmige, dünne lichtempfindliche Schicht einzusetzen, sondern den Formzylinder bzw. die Formzylinder-Hülse mit zwei oder mehr vorgefertigten bahnförmigen, dünnen lichtempfindlichen Schichten in mehreren Lagen zu umwickeln. Gleichermaßen ist es bei dieser Ausführungsform kein Erfordernis, daß durch die Umwicklung exakt 2, 3, 4 etc. Lagen gebildet werden, d.h. daß die achsparallel laufenden Endkanten der vorgefertigten bahnförmigen lichtempfindlichen Schicht bzw. lichtempfindlichen Schichten am Anfang und am Ende der Umwicklung exakt übereinander zu liegen kommen. Es ist durchaus möglich, daß bei der letzten Umwicklung nur ein Teil der Zylinderoberfläche umfaßt, diese letzte Lage also nur unvollständig ausgebildet wird. Erfindungsgemäß gefordert ist lediglich, daß der Formzylinder bzw. die Formzylinder-Hülse mit mindestens 2, vorzugsweise mit mindestens 3, vollständigen Lagen aus der vorgefertigten, dünnen lichtempfindlichen Schicht belegt wird.

Gemäß einer anderen Ausführungsform des erfindungsgemäßen Verfahrens kann der Formzylinder bzw. die Formzylinder-Hülse mit einer bahn- oder bandförmigen, vorgefertigten, dünnen lichtempfindlichen Schicht spiralförmig in mehreren Lagen umwickelt werden. Hierbei können die spiralförmigen Wicklungen der einzelnen Lagen gleichläufig oder auch gegenläufig ausgeführt werden. Weiterhin kann die spiralförmige Wicklung der vorgefertigten, dünnen lichtempfindlichen Schicht so durchgeführt werden, daß in jeder einzelnen Lage die Rand- bzw. Seitenbereiche der dünnen vorgefertigten lichtempfindlichen Schicht überlappen oder unmittelbar aneinanderstoßen. Werden die Formzylinder bzw. Formzylinder-Hülsen mit dünnen, vorgefertigten lichtempfindlichen Schichten spiralförmig so umwickelt, daß die Rand- bzw. Seitenbereiche der lichtempfindlichen Schichten in den einzelnen Lagen einander überlappen, so ist es vorteilhaft, wenn die Wicklung der folgenden Lage im Vergleich zur Wicklung der vorhergehenden Lage gegenläufig erfolgt. Bei gleichläufiger Wicklung ist es in diesem Fall günstig, die bahnförmigen, vorgefertigten, dünnen lichtempfindlichen Schichten in den einzelnen Lagen etwas gegeneinander zu versetzen, so daß die überlappenden Rand- bzw. Seitenbereiche zweier unmittelbar übereinander angeordneter Lagen nicht übereinander zu liegen kommen. Bei einer überlappenden Wicklung beträgt der Überlappungsbereich weniger als 50% der Breite der bahn- bzw. bandförmigen, vorgefertigten, dünnen lichtempfindlichen Schicht. Bevorzugt ist der Überlappungsbereich nicht mehr als 25%, insbesondere bis zu 15%, der Schichtbreite. In der Praxis hat es sich als günstig erwiesen, wenn bei einer überlappenden Wicklung die Rand- bzw. Seitenbereiche der vorgefertigten, dünnen lichtempfindlichen Schicht etwa 1 bis 10 cm übereinander liegen. Werden die bahn- bzw. bandförmigen, vorgefertigten, dünnen lichtempfindlichen Schichten spiralförmig so auf die Formzylinder bzw. Formzylinder-Hülsen aufgewickelt, daß die Rand- bzw. Seitenbereiche der vorgefertigten, dünnen lichtempfindlichen Schicht in den einzelnen, spiralförmig gewickelten Lagen nicht-überlappend aneinander stoßen, so ist darauf zu achten, daß vorzugsweise die hierdruch gebildeten Stoß- bzw. Nahtlinien in zwei unmittelbar übereinanderliegenden Lagen nicht zusammenfallen. Auch in diesem Fall ist es daher vorteilhaft, die spiralförmige Wicklung in den jeweils aufeinanderfolgenden Lagen gegenläufig auszuführen. Gleichermaßen ist es natürlich günstig, die spiralförmige Wicklung in den einzelnen Lagen gleichläufig durchzuführen, die bahn- bzw. bandförmigen, vorgefertigten, dünnen lichtempfindlichen Schichten hierbei jedoch von Lage zu Lage seitlich so zu versetzen, daß die Stoß- bzw. Nahtlinien der einzelnen Lagen nicht übereinander zu liegen kommen, sondern daß die Stoß- bzw. Nahtlinien der einen Lage durch die vorgefertigte, dünne lichtempfindliche Schicht der nächsten, darüber angeordneten Lage überdeckt sind.

Wesentlich für das erfindungsgemäße Verfahren ist es, daß das Beschichten des Druckzylinders bzw. der Druckzylinder-Hülse mit den einzelnen Lagen der dünnen vorgefertigten lichtempfindlichen Schicht blasenfrei unter Verdrängung der Luft zwischen den einzelnen übereinanderliegenden Lagen, sowie selbstverständlich auch zwischen dem Formzylinder bzw. der Formzylinder-Hülse und der ersten Lage der dünnen vorgefertigten lichtempfindlichen Schicht, erfolgt. Werden dabei in einer Lage End- und/oder Seitenbereiche der dünnen, vorgefertigten lichtempfindlichen Schichten überlappend zusammengelegt, so sollen natürlich auch diese Überlappungsbereiche frei von Blasen und Lufteinschlüssen sein. Das blasenfreie Aufbringen der einzelnen Lagen aus den dünnen, vorgefertigten lichtempfindlichen Schichten auf den Formzylinder bzw. die Formzylinder-Hülse kann beispielsweise durch entsprechendes luftverdrängendes Andrücken, z.B. mittels einer Walze, der dünnen, vorgefertigten lichtempfindlichen Schicht an den Formzylinder bzw. die Formzylinder-Hülse bzw. an die jeweils darunter liegende Lage aus der lichtempfindlichen Schicht erfolgen. Um dabei ein gutes Anschmiegen der jeweils aufzubringenden oberen Lage der lichtempfindlichen Schicht an den Untergrund, insbesondere auch im Bereich von Überlappungen von End- und/oder Seitenbereichen der vorgefertigten, dünnen lichtempfindlichen Schichten, unter Vermeidung der Ausbildung von Lufthohlräumen zu gewährleisten und sicherzustellen, kann es empfehlenswert und hilfreich sein, daß vorerwähnte luftverdrängende Andrücken der vorgefertigten, dünnen lichtempfindlichen Schicht unter Mitverwendung eines Kaschierhilfsmittels und/oder insbesondere unter dem Einfluß von Wärme durchzuführen. Beispielsweise kann hierbei ein Heißluftgebläse verwendet werden. Bei Mitverwendung von Kaschierhilfsmitteln werden diese vorteilhaft durch mechanisches Verdrängen und/oder durch Verdampfen beim Kaschiervorgang entfernt.

Erfindungsgemäß werden die Formzylinder bzw. Formzylinder-Hülsen mit mindestens 2 Lagen aus einer vorgefertigten, dünnen lichtempfindlichen Schicht belegt. Die maximal mögliche Anzahl der Lagen ergibt sich aus der gewünschten Gesamtdicke der lichtempfindlichen Schicht sowie der minimalen Stärke, mit der die einzusetzenden vorgefertigten, dünnen lichtempfindlichen Schichten hergestellt und erfindungsgemäß verarbeitet werden können. In der Praxis hat es sich als üblich erwiesen, 2 bis etwa 20 Lagen, insbesondere 3 bis 10 Lagen, aus der vorgefertigten, dünnen lichtempfindlichen Schicht auf den Formzylinder bzw. die Formzylinder-Hülse aufzubringen.

Zum haftfesten Verbinden und Verschmelzen der einzelnen, blasenfrei aufgebrachten Lagen der vorgefertigten, dünnen lichtempfindlichen Schicht sowie – je nach Art der Beschichtungsmethode – auch der End- und/oder Seitenbereiche dieser vorgefertigten, lichtempfindlichen Schicht wird erfindungsgemäß nach dem Beschichten des Formzylinders bzw. der Formzylinder-Hülse die gesamte lichtempfindliche Schichtmasse unter dem Einfluß von Druck so lange erwärmt, bis sich eine einzige, zusammenhängende, durchgehend verbundene lichtempfindliche Schicht gebildet hat. Die hierbei anzuwendenden Temperaturen richten sich in erster Linie nach den thermischen und rheologischen Eigenschaften der eingesetzten, vorgefertigten, dünnen lichtempfindlichen Schichten und liegen dabei mindestens so hoch, daß unter dem einwirkenden Druck die einzelnen übereinanderliegenden Lagen aus den vorgefertigten lichtempfindlichen Schichten verschmelzen bzw. ineinanderverfließen, jedoch nicht so hoch, daß die Eigenschaften der lichtempfindlichen Schicht dadurch beeinträchtigt werden. Im übrigen werden die Temperaturen so gewählt, daß das Verbinden und Verschmelzen der einzelnen Lagen aus der vorgefertigten, dünnen lichtempfindlichen Schicht sowie gegebenenfalls der End- und/oder Seitenkanten der vorgefertigten, dünnen lichtempfindlichen Schichten in angemessener Zeit abläuft. Üblicherweise werden hierzu Temperaturen von etwa 40 bis etwa 200°C, insbesondere Temperaturen im Bereich von etwa 80 bis 150°C, angewandt. Die Erwärmung der Schichtmasse kann dabei rückseitig, d.h. von der Seite des Formzylinders bzw. der Formzylinder-Hülse her, erfolgen, beispielsweise durch in dem Formzylinder bzw. in der Formzylinder-Hülse angeordnete Heizelemente. Für solche Heizelemente sind insbesondere elektrische Widerstandsheizungen geeignet. Es ist aber auch möglich, die Erwärmung der Schichtmasse von der äußeren Oberfläche der lichtempfindlichen Schicht her vorzunehmen, beispielsweise mittels Infrarot-, Mikrowellenstrahler, Heißluftgebläse oder dgl. Selbstverständlich können auch beide Methoden des Erwärmens, d.h. rückseitig und von der äußeren Schichtoberfläche her, gleichzeitig durchgeführt werden.

Der während des Erwärmens der lichtempfindlichen Schichtmasse auf die Schichtoberfläche wirkende Druck kann in an sich jeder beliebigen, geeigneten Weise erzeugt werden. Beispielsweise kann hierfür ein festes Druckelement, eine andrückbare, umlaufende Walze oder dgl. eingesetzt werden. Als besonders vorteilhaft zur Druckerzeugung hat sich das Anlegen eines Vakuums unter Absaugen von Luft und evtl. vorhandenen sonstigen Gasen erwiesen. Dieses kann in an sich bekannter Weise geschehen, beispielsweise durch gasdichtes Umhüllen der auf dem Formzylinder bzw. der Formzylinder-Hülse aufgebrachten Lagen aus der vorgefertigten, dünnen lichtempfindlichen Schicht mit z.B. einer Kunststoff-Folie oder Schrumpffolie und Evakuieren, wobei der Formzylinder bzw. die Formzylinder-Hülse vorzugsweise mit entsprechenden Absaugöffnungen oder oberflächlichen, das Absaugen von Gasen ermöglichenden Kanälen oder dgl. versehen ist. In diesem Zusammenhang sei auf den vorgehend zitierten Stand der Technik verwiesen. In einer möglichen vorteilhaften Ausgestaltungsform wird hierzu der Formzylinder bzw. die Formzylinder-Hülse, die mit einer Haftschicht versehen sein können, mit einem textilen Gewirke umhüllt, bevor hierauf die Lagen aus der vorgefertigten dünnen lichtempfindlichen Schicht aufgebracht werden, und wird anschließend nach gasdichter Umhüllung des beschichteten Formzylinders bzw. der beschichteten Formzylinder-Hülse mit einer Kunststoff-Folie Vakuum angelegt.

Die Zeit für die Wärme- und Druckbehandlung hängt im wesentlichen von der Art der eingesetzten, vorgefertigten, dünnen lichtempfindlichen Schicht und den Verfahrensbedingungen ab und liegt üblicherweise im Bereich von etwa 10 bis 120 Minuten.

Durch das Erwärmen unter dem Einfluß von Druck wird ein Verbinden und Verschmelzen der auf dem Formzylinder bzw. der Formzylinder-Hülse angeordneten einzelnen Lagen aus der vorgefertigten, dünnen lichtempfindlichen Schicht sowie – je nach Art der Beschichtungsmethode – auch der End- und/oder Seitenbereiche dieser lichtempfindlichen Schichten unter Ausbildung einer einzigen, durchgehend verbundenen lichtempfindlichen Schicht auf dem Formzylinder bzw. der Formzylinder-Hülse bewirkt. Im Anschluß daran wird – in aller Regel nach Abkühlen der lichtempfindlichen Schicht – die Oberfläche der erhaltenen, verbundenen, durchgehenden lichtempfindlichen Schicht einer maßgenauen formgebenden, insbesondere mechanischen, Nachbehandlung unterzogen, um eine exakt zylindrische Oberfläche des so beschichteten Formzylinders bzw. der so beschichteten Formzylinder-Hülse zu erzeugen, wie es für die Herstellung von Rotationsdruckformen notwendig und erforderlich ist. Diese maßgenaue formgebende Nachbehandlung ist insbesondere bedeutungsvoll, wenn konisch zulaufende Formzylinder-Hülsen erfindungsgemäß mit einer dünnen, vorgefertigten lichtempfindlichen Schicht beschichtet worden sind. In diesem Fall muß nämlich durch die formgebende Nachbehandlung auch die längenaxiale Ab- bzw. Zunahme im Durchmesser der konisch zulaufenden Hülse ausgeglichen werden, um eine exakt zylindrische Oberfläche der mit der lichtempfindlichen Schicht belegten Hülse zu erhalten. Die formgebende Nachbehandlung kann nach an sich jeder geeigneten Methode erfolgen und wird vorzugsweise durch eine mechanische Bearbeitung der Schichtoberfläche, wie z.B. Abdrehen, Abspänen, Schleifen oder dgl., vorgenommen. Die Glättung der Oberfläche der so nachbehandelten lichtempfindlichen Schicht kann nach an sich bekannten und üblichen Verfahrensweisen, beispielsweise durch eine Lösungsmittel-Behandlung, mittels Glättwalzen oder dgl., erfolgen. Die formgebende Nachbehandlung und Glättung können auch eine geeignete thermische Behandlung, wie z.B. Heißkalandrieren, beinhalten.

Nach dem erfindungsgemäßen Verfahren resultieren Formzylinder bzw. Formzylinder-Hülsen, die mit einer durchgehenden, nahtlosen, glatten lichtempfindlichen Schicht beschichtet sind und die sich in hervorragender Weise für die Herstellung von Rotationsdruckformen, insbesondere für den Flexodruck oder den Tiefdruck, eignen. Zur Herstellung der Druckformen wird die auf dem Formzylinder bzw. der Formzylinder-Hülse aufgebrachte lichtempfindliche Schicht in an sich bekannter Weise bildmäßig mit aktinischem Licht belichtet und anschließend, insbesondere durch Auswaschen mit einem Entwicklerlösungsmittel, entwickelt. An die Entwicklung können sich gewünschtenfalls die üblichen Nachbehandlungsschritte, wie z.B. Nachbelichtung, Trocknung oder eine sonstige Wärmebehandlung, anschließen. Die nach dem erfindungsgemäßen Verfahren erhaltenen, mit einer durchgehenden, nahtlosen lichtempfindlichen Schicht beschichteten Formzylinder oder Formzylinder-Hülsen können vor ihrer weiteren Verwendung auch mit einer Schutzfolie, Lackschicht, mattierten Folie oder dgl. überzogen werden. Die Druckformen, die aus den nach dem erfindungsgemäßen Verfahren erhaltenen, mit einer lichtempfindlichen Schicht nahtlos beschichteten Formzylindern oder Formzylinder-Hülsen hergestellt werden, liefern ausgezeichnete Druckergebnisse im Rotationsdruck und lassen sich insbesondere auch ohne Probleme beim Endlosdruck verwenden.

Die Erfindung wird durch die nachfolgenden Beispiele näher erläutert.

Beispiel 1

Eine mit einem Haftlack versehene, zylindrische Nickel-Hülse wurde mehrmals mit einer lösungsmittelfreien und trägerfreien, bahnförmigen, lichtempfindlichen, photopolymerisierbaren Schicht einer Stärke von 0,2 mm so umwickelt, daß eine blasenfreie Belegung der Zylinderhülse resultierte. Die lichtempfindliche, photopolymerisierbare Schicht war dabei gemäß Vergleichsversuch A der EP-A-70 510 hergestellt worden. Nach Umhüllen der mit der lichtempfindlichen Schicht umwickelten Hülse mit einer gasdichten Folie und Anlegung eines Unterdrucks zwischen lichtempfindlicher Schicht und Hülse wurde die gesamte lichtempfindliche Schicht für ca. 30 Minuten auf 130°C erwärmt. Danach waren die einzelnen Lagen der lichtempfindlichen Schicht fest miteinander verbunden, als auch resultierte ein festhaftender Verbund zwischen der lichtempfindlichen Schicht und der Nickelhülse. Nach Abkühlen und Entfernen der gasdichten Folie wurde die Obefläche der lichtempfindlichen Schicht durch Abdrehen mit einem Hartmetall-Werkzeug auf das gewünschte exakt zylindrische Maß gebracht. Schließlich wurde durch Schleifen und Heißkalandrieren die Schichtoberfläche geglättet. Es resultierte eine Zylinderhülse mit einer nahtlosen, glatten durchgehenden lichtempfindlichen Schicht. Gemäß dem Verfahren von Beispiel 1 der EP-A-70 510 konnte hieraus durch bildmäßiges Belichten mit aktinischem Licht und Entwickeln mit einem Entwicklerlösungsmittel eine einwandfreie Druckform für den Rotationstiefdruck hergestellt werden.

Beispiel 2

Es wurde wie in Beispiel 1 verfahren, diesmal wurde jedoch die bahnförmige lichtempfindliche Schicht, deren Dicke 0,15 mm betrug, auf eine leicht konische Nickel-Hülse aufgewickelt. Durch Erwärmen mit einem Heißluftgebläse wurde dabei sichergestellt, daß sich die einzelnen Lagen beim Umwickeln ohne Lufteinschlüsse glatt aufeinanderlegten. Die Oberfläche der konisch zulaufenden Nickelhülse war zuvor wiederum mit einem Haftlack versehen worden, diesmal jedoch zur Erleichterung des Evakuierens vor dem Belegen mit der photopolymerisierbaren Schicht zusätzlich mit einem feinmaschigen Strumpf aus Kunstfaser überzogen worden. Die Nickelhülse wurde in vier Lagen mit der bahnförmigen photopolymerisierbaren Schicht umwickelt. Nach dem Evakuieren, Erwärmen, Abdrehen und Glätten wie in Beispiel 1 wurde eine einzige, durchgehende, glatte lichtempfindliche Schicht mit exakt zylindrischer Oberfläche erhalten, die haftfest mit der Nickel-Hülse verbunden war. Die hieraus hergestellte Tiefdruckform lieferte ausgezeichnete Ergebnisse im Druckverfahren.

Beispiel 3

Eine 0,3 mm dicke, bahnförmige, photopolymerisierbare Schicht auf Basis eines alkohol-löslichen Polyamids entsprechend Beispiel 1 der EP-A-46 047 wurde in gleicher Weise, wie in Beispiel 1 beschrieben, auf eine Zylinder-Hülse aufgewickelt. Die Zylinderhülse bestand diesesmal jedoch aus einem Phenolharz, und die Umwicklung wurde so durchgeführt, daß eine zweilagige Bedeckung resultierte. Ferner waren die achsparallelen Endkanten der bahnförmigen lichtempfindlichen Schicht vor dem Umwickeln der Zylinder-Hülse keilförmig abgeschrägt worden. Im übrigen wurde wie in Beispiel 1 beschrieben verfahren. Auch in diesem Fall konnte eine Druckform hergestellt werden, die ausgezeichnete Ergebnisse im rotativen Hochdruck lieferte.

Beispiel 4

Eine 0,4 mm dicke, bahnförmige, photopolymerisierbare Schicht gemäß Beispiel 1 der DE-A-29 42 183 wurde so um eine mit einem Haftlack versehene Nickel-Hülse gewickelt, daß die Nickelhülse mit vier Lagen der photopolymerisierbaren Schicht belegt war. Im übrigen wurde wie in Beispiel 1 beschrieben gearbeitet. Nach dem Schleifen und Kalandrieren resultierte eine Zylinder-Hülse, die mit einer durchgehenden, glatten lichtempfindlichen Schicht mit exakt zylindrischer Oberfläche belegt war und die sich hervorragend für die Herstellung von Flexodruckformen eignete.

## Ansprüche

1. Verfahren zum Beschichten eines Formzylinders oder einer Formzylinder-Hülse mit einer durchgehenden, nahtlosen, lichtempfindlichen Schicht durch haftfestes Aufbringen einer vorgefertigten, festen, thermoplastisch verarbeitbaren lichtempfindlichen Schicht auf den Formzylinder bzw. die Formzylinder-Hülse unter dem Einfluß von Wärme und Druck, dadurch gekennzeichnet, daß es sich bei der vorgefertigten, festen, thermoplastisch verarbeitbaren lichtempfindlichen Schicht um eine dünne, im wesentlichen lösungsmittelfreie, trägerfreie bahn- oder bandförmige lichtempfindliche Schicht handelt, die mehrfach in mindestens zwei übereinanderliegenden Lagen blasenfrei unter Verdrängung der Luft zwischen den einzelnen Lagen um den Formzylinder bzw. die Formzylinder-Hülse gewickelt wird, worauf die gesamte aufgebrachte lichtempfindliche Schichtmasse unter Druck und Verbinden bzw. Verschmelzen der einzelnen Lagen erwärmt und anschließend die so auf dem Formzylinder bzw. der Formzylinder-Hülse erzeugte durchgehend verbundene lichtempfindliche Schicht unter Ausbildung einer exakt zylindrischen Oberfläche formgebend nachbehandelt und geglättet wird.

2. Verfahren nach Anspruch 1, dadurch gekennzeichnet, daß eine vorgefertigte bahnförmige lichtempfindliche Schicht achsparallel um den Formzylinder bzw. die Formzylinder-Hülse gewickelt wird.

3. Verfahren nach Anspruch 1, dadurch gekennzeichnet, daß zum Beschichten des Formzylinders bzw. der Formzylinder-Hülse eine vorgefertigte, bahn- oder bandförmige lichtempfindliche Schicht spiralförmig in mehreren Lagen um den Formzylinder bzw. die Formzylinder-Hülse gewickelt wird.

4. Verfahren nach einem der Ansprüche 1 bis 3, dadurch gekennzeichnet, daß zum Beschichten des Formzylinders bzw. der Formzylinder-Hülse solche lösungsmittelfreien, vorgefertigten, dünnen, lichtempfindlichen Schichten eingesetzt werden, die unter den Verarbeitungsbedingungen nicht gasen.

5. Verfahren nach einem der Ansprüche 1 bis 4, dadurch gekennzeichnet, daß die auf den Formzylinder bzw. die Formzylinder-Hülse lagenförmig aufgebrachte, lichtempfindliche Schichtmasse auf eine Temperatur im Bereich von etwa 80 bis 150°C erwärmt wird.

6. Verfahren nach einem der Ansprüche 1 bis 5, dadurch gekennzeichnet, daß der Druck etwa 0,1 bis 1 kg/cm² beträgt.

7. Verfahren nach einem der Ansprüche 1 bis 6, dadurch gekennzeichnet, daß der Formzylinder bzw. die Formzylinder-Hülse vor dem Aufbringen der lichtempfindlichen Schicht mit einem Haftlack oder einer Haftschicht versehen worden ist.

8. Verfahren nach einem der Ansprüche 1 bis 7, dadurch gekennzeichnet, daß das Erwärmen der lichtempfindlichen Schichtmasse unter Einwirkung eines Vakuums zwischen Formzylinder bzw. Formzylinder-Hülse und lichtempfindlicher Schicht bzw. einer sie abdeckenden Kunststoff-Folie oder Schrumpffolie erfolgt.

9. Verfahren nach einem der Ansprüche 1 bis 8, dadurch gekennzeichnet, daß die formgebende Nachbehandlung mechanisch durch Abdrehen, Abspänen oder Schleifen erfolgt.

10. Verwendung der nach einem der Ansprüche 1 bis 9 hergestellten, mit einer durchgehenden, glatten lichtempfindlichen Schicht beschichteten Formzylinder bzw. Formzylinder-Hülsen zur Herstellung von Hochdruckformen, insbesondere Flexodruckformen.

11. Verwendung der nach einem der Ansprüche 1 bis 9 hergestellten, mit einer durchgehenden, glatten lichtempfindlichen Schicht beschichteten Formzylinder bzw. Formzylinder-Hülsen zur Herstellung von Tiefdruckformen.

## Claims

1. A process for coating a printing cylinder or a sleeve with a continuous, seamless, photosensitive layer, by firmly applying a prefabricated, solid, thermoplastically processible photosensitive layer to the printing cylinder or the sleeve under the influence of heat and pressure, wherein the said layer is a thin, essentially solvent-free, base-free, web-like or belt-like photosensitive layer which is wound several times around the printing cylinder or the sleeve in two or more strata lying one on top of the other, without bubbles and with displacement of the air between the individual strata, after which the total photosensitive layer material applied is heated under pressure and with joining or fusion of the individual strata, and the continuously joined photosensitive layer produced in this manner on the printing cylinder or on the sleeve is then subjected to a shaping aftertreatment and is smoothed, with formation of an exactly cylindrical surface.

2. A process as claimed in claim 1, wherein a prefabricated web-like photosensitive layer is wound around the printing cylinder or the sleeve parallel to the axis.

3. A process as claimed in claim 1, wherein, for coating the printing cylinder or the sleeve, a prefabricated, web-like or belt-like photosensitive layer is wound spirally in a plurality of strata around the printing cylinder or the sleeve.

4. A process as claimed in any of claims 1 to 3, wherein, for coating the printing cylinder or the sleeve, solvent-free, prefabricated, thin, photosensitive layers which do not form a gas under the processing conditions are used.

5. A process as claimed in any of claims 1 to 4, wherein the photosensitive layer material applied in the form of strata on the printing cylinder or on the sleeve is heated at from about 80 to 150°C.

6. A process as claimed in any of claims 1 to 5, wherein the pressure is about 0.1-1 kg/cm².

7. A process as claimed in any of claims 1 to 6, wherein the printing cylinder or the sleeve has been provided with a mixture of adhesion-promoting components or an adhesion-promoting layer prior to application of the photosensitive layer.

8. A process as claimed in any of claims 1 to 7, wherein heating of the photosensitive layer material is carried out under reduced pressure between the printing cylinder or sleeve and the photosensitive layer or a plastic film or shrink film covering the latter.

9. A process as claimed in any of claims 1 to 8, wherein the shaping aftertreatment is carried out mechanically by turning, cutting or grinding.

10. Use of a printing cylinder or sleeve, produced as claimed in any of claims 1 to 9 and coated with a continuous, smooth photosensitive layer, for the production of letterpress printing plates, in particular flexographic printing plates.

11. Use of a printing cylinder or sleeve, produced as claimed in any of claims 1 to 9 and coated with a continuous, smooth photosensitive layer, for the production of gravure printing plates.

## Revendications

1. Procédé de revêtement d'un cylindre porte-forme ou d'un manchon de cylindre porte-forme d'une couche photosensible continue sans joint, par application avec adhérence sur celui-ci, sous l'action de chaleur et de pression, d'une couche photosensible thermoplastique solide préfabriquée, caractérisé par le fait que la couche photosensible thermoplastique solide préfabriquée est une couche photosensible mince en forme de bande, sans support et pratiquement sans solvant, qui est enroulée plusieurs fois en au moins deux strates superposées, sans bulles, avec expulsion de l'air se trouvant entre les différentes strates, autour du cylindre porte-forme ou du manchon de cylindre porte-forme, après quoi la totalité de la masse de couche photosensible appliquée est chauffée sous pression pour l'union ou la fusion des différentes strates et ensuite, la couche photosensible unie continue ainsi produite sur le cylindre porte-forme ou le manchon de cylindre porte-forme est façonnée et lissée pour la formation d'une surface exactement cylindrique.

2. Procédé selon la revendication 1, caractérisé par le fait qu'une couche photosensible en forme de bande préfabriquée est enroulée pararlèlement à l'axe autour du cylindre porte-forme ou du manchon de cylindre porte-forme.

3. Procédé selon la revendication 1, caractérisé par le fait que, pour le revêtement du cylindre porte-forme ou du manchon de cylindre porte-forme, une couche photosensible en forme de bande préfabriquée est enroulée en hélice en plusieurs strates autour de celui-ci.

4. Procédé selon l'une des revendications 1 à 3, caractérisé par le fait que pour le revêtement du cylindre porte-forme ou du manchon de cylindre porte-forme sont utilisées des couches photosensibles minces préfabriquées sans solvant qui ne dégagent pas de gaz dans les conditions de mise en oeuvre.

5. Procédé selon l'une des revendications 1 à 4, caractérisé par le fait que la masse de couche photosensible appliquée en strates sur le cylindre porte-forme ou le manchon de cylindre porte-forme est chauffée à une température d'environ 80 à 150 degrés C.

6. Procédé selon l'une des revendications 1 à 5, caractérisé par le fait que la pression est d'environ 0,1 à 1,0 kg/cm².

7. Procédé selon l'une des revendications 1 à 6, caractérisé par le fait que le cylindre porte-forme ou le manchon de cylindre porte-forme est, avant l'application sur lui de la couche photosensible, revêtu d'un vernis adhésif ou d'une couche adhésive.

8. Procédé selon l'une des revendicatoins 1 à 7, caractérisé par le fait que le chauffage de le masse de couche photosensible est effectué avec action d'un vide entre le cylindre porte-forme ou le manchon de cylindre porte-forme et la couche photosensible ou une feuille de plastique ou une feuille rétractable couvrant cette couche.

9. Procédé selon l'une des revendications 1 à 8, caractérisé par le fait que le traitement postérieur de façonnage est fait mécaniquement par tournage, ébarbage ou rectification.

10. Utilisation des cylindres porte-forme ou des manchons de cylindres porte-forme revêtus d'une couche photosensible lisse continue réalisés selon l'une des revendications 1 à 9 pour la production de formes d'impression en relief, en particulier de formes de flexographie.

11. Utilisation des cylindres porte-forme ou des manchons de cylindres porte-forme revêtus d'une couche photosensible lisse continue réalisés selon l'une des revendications 1 à 9 pour la production de formes d'impression en creux.